# EUROPÄISCHE PATENTANMELDUNG

(11) **EP 4 817 961 A1**
(43) Veröffentlichungstag der Anmeldung: **07.10.2026**
(21) Anmeldenummer: 26168860.0
(22) Anmeldetag: 30.03.2026
(51) Int. Cl.: B60R 16/023, B65D 43/02, B65D 43/16, H02B 1/06, H02B 1/46, H02G 3/08, H05K 5/15, H05K 5/03

(54) **ELEKTROBOX FÜR EIN KRAFTFAHRZEUG**

(30) Priorität: 31.03.2025 DE 102025112531
(71) Anmelder: LEONI Bordnetz-Systeme GmbH, 97318 Kitzingen (DE)
(72) Erfinder: KLOTZBÜCHER, Kai, 97320 Mainstockheim (DE)
(74) Vertreter: FDST Patentanwälte

(57) **Zusammenfassung**

Die Erfindung betrifft eine Elektrobox (2) für ein Kraftfahrzeug mit zwei Teilen, nämlich einem Deckelteil (6A, 6B) und einem weiteren Teil (6B, 6A), wobei das Deckelteil (6A, 6B) relativ zu dem weiteren Teil (6B, 6A) von einer geschlossenen Stellung in eine geöffnete Stellung um eine Schwenkachse (S) aufklappbar und in der geöffneten Stellung arretierbar ist, wobei in einem der beiden Teile (6A) eine Federlasche (18) mit Hilfe eines ersten Trennschlitzes (20A) freigeschnitten ist und dass an dem anderen Teil (6B) ein Raststeg (22) angeordnet ist, welcher beim Überführen des Deckelteils (6A, 6B) in die geöffnete Stellung von der Federlasche (18) hintergriffen wird und dadurch das Deckelteil (6A, 6B) in der geöffneten Stellung arretiert.

## Beschreibung

Die Erfindung betrifft eine Elektrobox für ein Kraftfahrzeug mit einem Deckelteil, welches von einer geschlossenen Stellung in eine geöffnete Stellung um eine Schwenkachse aufklappbar und in der geöffneten Stellung arretierbar ist.

Die Elektrobox ist typischerweise als eine Verteilerbox und/oder eine Sicherungsbox ausgebildet. In eine solche Elektrobox werden üblicherweise mehrere elektrische Leitungen eingeführt, die innerhalb der Elektrobox geeignet miteinander verbunden werden. Derartige Elektroboxen werden üblicherweise von einem Zulieferer an den Automobilhersteller geliefert, wobei bei der (End-) Montage noch Anschlussarbeiten zum Anschließen der Leitungen innerhalb der Box erforderlich sind. Um bei der Montage einen einfachen Zugriff in den Innenraum der Elektrobox zu ermöglichen, ist es bekannt, dass ein Deckelteil der Elektrobox geöffnet und in einer geöffneten Stellung arretiert werden kann. Nach der Montage wird das Deckelteil wieder verschlossen.

Derartige Elektroboxen sind beispielsweise zu entnehmen aus JP 5 707 194 B2 oder auch der JP 6 335 687 B2. Bei der JP 5 707 194 B2 ist am verschwenkbaren Deckelteil ein abstehender Raststeg angebracht. Weiterhin ist in einem rückwärtigen Teilbereich ein vertikal abstehender Haltesteg mit einer vorspringenden Rastnase ausgebildet, welche von dem Raststeg in der geöffneten Stellung des Deckelteils hintergriffen wird. Derartige abstehenden Strukturen sorgen beim Betrieb sowie beim Transport für eine erhöhte Bruchgefahr für derartige Teile. Bei der JP 6 335 687 B2 ist am schwenkbaren Deckelteil zunächst ein vertikal abstehendes Teilstück ausgeformt, an dem in Querrichtung Rastnasen angeformt sind, welche mit einem an einem rückwärtigen Teilbereich ausgebildeten und mit einer Rastaufnahme versehenen Halteelement in der geöffneten Stellung verrastet werden. Die bekannten Lösungen weisen insgesamt eine vergleichsweise komplexe dreidimensionale Deckelgeometrie auf. Die Deckel werden üblicherweise als Spritzgussteile ausgebildet. Aufgrund der komplexen Deckelgeometrie sind regelmäßig Hinterschnitte ausgebildet, die eine aufwändige Werkzeugform für den Spritzgussprozesses erforderlich machen, insbesondere mit verschiebbaren Stempeln oder Schieberelementen, um die Hinterschnitte ausbilden zu können.

Ausgehend hiervon liegt der Erfindung die Aufgabe zugrunde, eine Elektrobox mit einem in einer geöffneten Stellung arretierbaren Deckelteil anzugeben, welches einfach herzustellen ist.

Die Aufgabe wird gemäß der Erfindung gelöst durch eine Elektrobox für ein Kraftfahrzeug mit den Merkmalen des Anspruchs 1. Die Elektrobox weist zwei Teile auf, nämlich ein Deckelteil und ein weiteres Teil, wobei das Deckelteil relativ zu dem weiteren Teil von einer geschlossenen Stellung in eine geöffnete Stellung um eine Schwenkachse aufklappbar und in der geöffneten Stellung arretierbar ist.

Hierzu ist in einem der beiden Teile eine Federlasche mit Hilfe eines Trennschlitzes, nämlich mit Hilfe eines ersten Trennschlitzes freigeschnitten. An dem anderen Teil ist ein Raststeg angeordnet ist, welcher beim Überführen des Deckelteils in die geöffnete Stellung von der Federlasche hintergriffen wird und dadurch das Deckelteil in der geöffneten Stellung arretiert.

Die Arretierung wird umgekehrt wieder durch Zuklappen in entgegengesetzter Schwenkrichtung aufgehoben. Durch die freigeschnittene Federlasche weist diese eine ausreichende Biegeflexibilität auf, sodass sie elastisch nachgiebig ist und beim Kontakt mit dem Raststeg verbogen wird, bis sie auf die andere Seite des Raststegs überschnappt. Zwischen der Federlasche und dem Raststeg wird daher eine Rastverbindung und damit eine Schnappverbindung ausgebildet.

Der besondere Vorteil bei dieser Ausgestaltung ist darin zu sehen, dass durch ein einfaches Freischneiden der Federlasche und durch die Ausbildung des abstehenden Raststegs eine zuverlässige Arretierung des Deckelteils ermöglicht ist. Durch die einfache Formgebung kann ein einfaches Formgebungswerkzeug, insbesondere Spritzgusswerkzeug für die Herstellung herangezogen werden. Es sind für die Arretierfunktion keine Hinterschneidungen erforderlich und auch nicht ausgebildet. Bevorzugt ist daher die gesamte Deckelstruktur im Hinblick auf die Ausbildung der für die Arretierfunktion notwendigen Elemente frei von Hinterschnitten. Auch bei dem Raststeg sind keine Hinterschneidungen erforderlich daher auch nicht ausgebildet. Durch das Freischneiden der Federlasche wird insgesamt eine sehr flache Deckelstruktur erreicht.

Unter freigeschnittene Federlasche wird vorliegend allgemein verstanden, dass die Federlasche nur mit einer Basis mit dem restlichen Bauteil verbunden ist und ansonsten frei absteht. Diese "freigeschnittene" Ausgestaltung wird beim Spritzgießen durch geeignete Ausgestaltung des Formgebungswerkzeuges erreicht, ohne dass also separate zusätzliche Schritte wie z.B. ein aktives Abtrennen / Freischneiden erforderlich ist und auch nicht erfolgt.

Die Federlasche ist üblicherweise lediglich noch an einer Grundseite mit dem restlichen Teil verbunden und ist daher durch die Freischneidung quasi frei abstehend ausgebildet. Diese Grundseite bildet beispielsweise eine Biegekante, um die die Federlasche gebogen werden kann. Bevorzugt ist die Federlasche über ihre gesamte Länge insgesamt auch biegeelastisch ausgebildet, sodass sie beim Arretiervorgang vorzugsweise insgesamt gebogen wird.

In bevorzugter Ausgestaltung ist das weitere Teil ebenfalls ein Deckelteil und die beiden Deckelteile bilden einen gemeinsamen Deckel aus. D.h. die Elektrobox weist einen Deckel auf mit zwei zueinander um die Schwenkachse schwenkbaren Deckelteilen, wobei die Federlasche an dem einen Deckelteil und der Raststeg an dem einem anderen Deckelteil ausgebildet sind.

Die Elektrobox weist allgemein ein Grundgehäuse auf, in dem die elektrischen Komponenten der Elektrobox aufgenommen sind. Dieses Grundgehäuse ist insgesamt mit dem Deckel verschlossen. Ein Teilstück des Deckels, nämlich der eine Deckelteil, ist aufklappbar, um den Zugang in das Innere des Grundgehäuses freizugeben. Diese Ausgestaltung ist herstellungstechnisch einfach durch ein Spritzgussteil zu verwirklichen.

Alternativ zu der Ausgestaltung, bei der die Federlasche und der Raststeg jeweils an einem Deckelteil ausgebildet sind, besteht auch die Möglichkeit, dass eines dieser Teile, insbesondere der Raststeg nicht Bestandteil des Deckels ist, sondern beispielsweise an einem anderen Gehäuseteil angebracht oder ausgebildet ist und dass das Deckelteil beispielsweise an diesem Gehäuseteil schwenkbar angebracht ist. Das andere Gehäuseteil ist beispielsweise ein Teilbereich des Grundgehäuses.

Das Deckelteil bzw. beide Deckelteile wird / werden üblicherweise über geeignete Verschlusselemente mit dem Grundgehäuse in der geschlossenen Stellung verbunden. Insbesondere sind hierzu Schnappelemente / Rastelemente vorgesehen, mit deren Hilfe das zumindest eine Deckelteil am Grundgehäuse gehalten ist. Zur Verschwenkung des Deckelteils wird zunächst das zumindest eine Verschlusselement gelöst, mit dem das Deckelteil mit dem Grundgehäuse verbunden ist.

Bevorzugt ist der Deckel insgesamt einstückig und insbesondere monolithisch ausgebildet und die beiden Deckelteile sind über ein Filmscharnier miteinander verbunden. Für die Verschwenkbarkeit der Deckelteile zueinander sind daher keine Lager und Lagerbauteile erforderlich und auch nicht vorgesehen. Bei dem Deckel handelt es sich insgesamt bevorzugt um ein monolithisches SpritzgussBauteil. Alternativ hierzu sind die beiden Deckelteile als getrennte Bauteile ausgebildet, welche über zumindest ein Scharnier miteinander verbunden sind.

Das Filmscharnier ist durch eine nur dünne Materialbrücke zwischen den beiden Deckelteilen ausgebildet, weist also eine (wesentlich) dünnere Materialstärke als der sonstige Deckel auf.

Gemäß einer bevorzugten Weiterbildung weist die Federlasche eine Wanddicke auf, die im Vergleich zu einer Wanddicke des der Federlasche benachbarten Bereichs reduziert ist. Die Wanddicke der Federlasche beträgt beispielsweise maximal 80 % oder maximal 50 % der Wanddicke des benachbarten Bereichs.

Alternativ oder ergänzend hierzu ist die Federlasche beispielsweise über eine Materialverjüngung mit dem restlichen Deckelteil verbunden. Hierdurch wird insgesamt eine gewünschte Biegeelastizität der Federlasche erzeugt.

In bevorzugter Ausgestaltung tritt der Raststeg - wenn sich das Deckelteil in der geschlossenen Stellung befindet - bezüglich einer Ebene der Federlasche aus dieser Ebene heraus und ist zu dieser Ebene insbesondere senkrecht orientiert. Die Federlasche befindet sich aufgrund des Freischneidens allgemein innerhalb der Ebene des Teils, insbesondere des einen Deckelteils, aus der sie freigeschnitten ist.

In bevorzugter Weiterbildung ist ausgehend vom Raststeg eine Decklasche ausgebildet, die in Richtung zu der Federlasche orientiert ist und die sich über die Schwenkachse und insbesondere über das Filmscharnier hinweg erstreckt. Der besondere Vorteil dieser Ausgestaltung ist darin zu sehen, dass durch diese Maßnahme ein für die Freischneidung erforderlicher Trennschlitz, welcher in Richtung zu der Schwenkachse orientiert ist, besonders dünn ausgebildet sein kann und/oder die Anforderungen an die Spritzgussform beim Spritzgussprozess geringer sind im Vergleich zu einer alternativen Ausgestaltung ohne eine solche Decklasche.

Um auch bei einer solchen alternativen Ausgestaltung ohne derartige Decklasche einen möglichst schmalen Trennschlitz zu erreichen, ist zwischen dem Trennschlitz und der Schwenkachse bzw. dem Filmscharnier noch ein Teilstück des Deckelteils ausgebildet, in dem auch die Federlasche ausgebildet ist. Dieses Teilstück ist daher sehr schmal, was spritzgusstechnisch aufwändig ist.

Die Decklasche ist in bevorzugter Weiterbildung fest und zwar insbesondere drehfest mit dem Raststeg verbunden und erstreckt sich vorzugsweise auch innerhalb der Ebene der Federlasche, wenn sich das Deckelteil in der geschlossenen Stellung befindet. Unter fest verbunden wird vorliegend verstanden, dass der Raststeg und die Decklasche ihre Relativposition zueinander nicht verändern können. In der geschlossenen Stellung fluchten daher die beiden Laschen vorzugsweise miteinander. Der Raststeg und die Decklasche bilden daher gemeinsam eine L-förmige Querschnittskontur aus.

In bevorzugter Ausgestaltung erstreckt sich bei der Ausführungsvariante mit dem Filmscharnier die Decklasche über das Filmscharnier hinweg, welches also durch die Decklasche unterbrochen ist. Insgesamt erstreckt sich daher die Decklasche in etwa zungenförmig über das Filmscharnier hinweg und reicht insbesondere ein Teilstück in das andere Deckelteil hinein. Die Decklasche ist über einen weiteren Trennschlitz, der nachfolgend als zweiter Trennschlitz bezeichnet wird, quasi aus dem Deckel freigeschnitten. Die Decklasche steht daher in Richtung zu dem Deckelteil, in dem die Federlasche ausgebildet ist, frei ab.

Die freigeschnittene Federlasche und die freigeschnittene Decklasche sind daher mit ihren freien Enden aufeinander zugewandt, wobei diese freien Enden durch einen weiteren Trennschlitz, nämlich einen dritten Trennschlitz voneinander getrennt sind. Dieser bildet daher zugleich ein Teilstück des ersten sowie des zweiten Trennschlitzes.

In bevorzugter Ausgestaltung weist der jeweilige Trennschlitz, insbesondere sämtliche Trennschlitze, also sowohl der erste Trennschlitz, mit der die Federlasche freigeschnitten ist, der zweite Trennschlitz, mit der die Decklasche freigeschnitten ist und entsprechend auch der dritte Trennschlitz zwischen den beiden Laschen, eine maximale Schlitzbreite kleiner 2,5 mm insbesondere kleiner 2 mm auf. Beispielsweise liegt die Schlitzbreite des jeweiligen Trennschlitzes zwischen 0,7 mm 1,5 mm. Durch diese Maßnahme wird erreicht, dass der Deckel und insbesondere die Elektrobox insgesamt der Schutzart IP 32 gemäß ISO 20653 entspricht. Gemäß dieser Schutzklasse ist die Elektrobox daher gegen das Eindringen fester Fremdkörper mit einem Durchmesser von 2,5 mm oder mehr geschützt und ist weiterhin außerdem gegen senkrechtes Tropfwasser geschützt, wenn die Elektrobox bis zu 15 % geneigt ist.

Die Elektrobox ist insgesamt in bevorzugter Ausgestaltung als eine Verteilerbox ausgebildet, in die im montierten Zustand mehrere elektrische Leitungen hineingeführt sind. Innerhalb der Elektrobox sind elektrische Komponenten, insbesondere Leitungsverbinder angeordnet. Üblicherweise sind endseitig an den Leitungen Kabelschuhe angebracht, welche miteinander oder auch mit einer in der Elektrobox einliegenden Stromschiene insbesondere durch Schrauben verbunden werden. Über das geöffnete Deckelteil sind die Schrauben zugänglich. Ergänzend besteht auch die Möglichkeit, dass in der Elektrobox Sicherungen (gegen Überstrom) integriert sind. In diesem Fall ist die Verteilerbox zusätzlich auch als Sicherungsbox ausgebildet.

Die Schwenkachse und / oder das eine (verschlossene) Deckelteil überdeckt vorzugsweise die Sicherungen und über das geöffnete Deckelteil sind Anschlussterminals zugänglich, z.B. Anschlussbolzen / Schrauben z.B. für einen Kabelschuh, über die ein jeweiliges Kabel an eine Sicherung und / oder Stromschiene angeschlossen werden kann. Über das geöffnete Deckelteil sind daher allgemein Montageelemente zugänglich.

Bevorzugt ist das Deckelteil mit dem Raststeg in Richtung zu den Sicherungen angeordnet und das andere Deckelteil in Richtung zu den eingeführten Kabeln. Da auf der Deckelseite mit dem Raststege weniger Schlitze enthalten sind, ist hierdurch ein guter Schutz für die Sicherungen erhalten.

Die Elektrobox ist im montierten Zustand in einem Kraftfahrzeug, z.B. einem PKW oder LKW verbaut, beispielsweise im Motorraum oder alternativ auch im Innenraum des Kraftfahrzeugs.

Ein Ausführungsbeispiel der Erfindung wird nachfolgend anhand der Figuren näher erläutert. Diese zeigen in vereinfachten Darstellungen:
- FIG 1: eine perspektivische Darstellung einer Elektrobox mit angeschlossenen elektrischen Leitungen,
- FIG 2: eine perspektivische Darstellung eines vereinfacht dargestellten Deckels mit zwei Deckelteilen in einer geschlossenen Stellung,
- FIG 3: eine geschnittene Darstellung des Deckels gemäß FIG 2,
- FIG 4: eine perspektivische Darstellung des Deckels gemäß FIG 2 in der offenen Stellung
- FIG 5: eine geschnittene Darstellung des Deckels in der offenen Stellung gemäß FIG 4,
- FIG 6: eine Gesamtdarstellung des Deckels in der offenen Stellung sowie
- FIG 7: eine Gesamtdarstellung des Deckels in der geschlossenen Stellung.

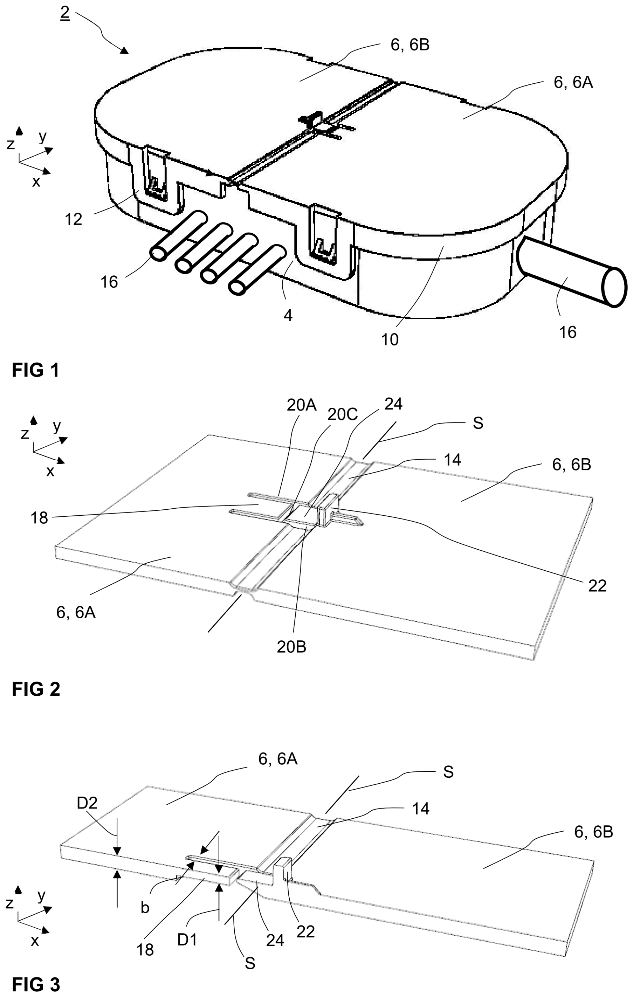

Eine in der FIG 1 dargestellte Elektrobox 2 weist ein Grundgehäuse 4 und einen Deckel 6 auf, über den das Grundgehäuse 4 verschlossen ist. Durch das Grundgehäuse 4 und den Deckel 6 ist die Elektrobox 2 geschlossen ausgebildet und genügt einer vorgegebenen Schutzart, insbesondere gemäß IP 32.

Der Deckel weist im Ausführungsbeispiel einen Deckelboden 8 auf, welcher vorzugsweise plan ausgebildet ist und eine x-y-Ebene aufspannt. An diesen schließt sich ein randseitig umlaufender und sich in einer z-Richtung erstreckender Randsteg 10 an, mit dem eine umlaufende Seitenwand des Grundgehäuses 4 im geschlossenen Zustand übergriffen ist. An diesem Randsteg 10 sind mehrere Verschlusselemente 12 insbesondere in Form von Rastöffnungen ausgebildet, welche mit zugeordneten weiteren Verschlusselementen am Grundgehäuse 4 zusammenwirken, die insbesondere als Rastnasen ausgebildet sind.

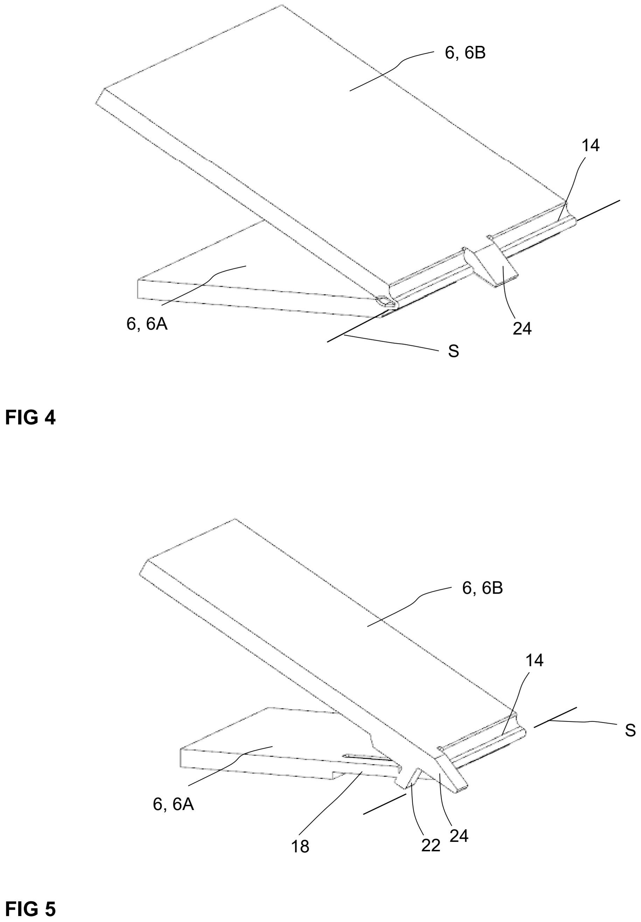

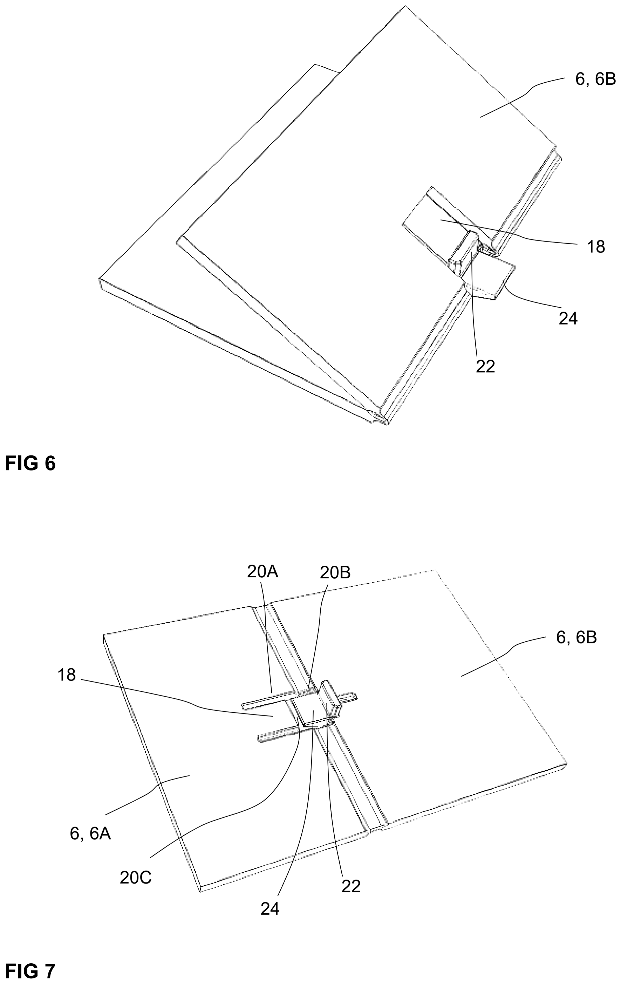

Der Deckel 6 weist zwei Deckelteil 6A, 6B auf, die zueinander schwenkbeweglich um eine Schwenkachse S sind. Die Schwenkachse S verläuft im Ausführungs-beispiel in Querrichtung (y-Richtung). Die beiden Deckelteil 6A, 6B können daher aus einer geschlossenen Stellung, wie sie in den Figuren 2 und 3 sowie in FIG 7 dargestellt ist, in eine aufgeklappte und geöffnete Stellung überführt werden, wie sie beispielhaft in Figuren 4 und 5 sowie in FIG 6 dargestellt ist. In der aufgeklappten Stellung sind die beiden Deckelteile 6A, 6B winklig zueinander fixiert und schließen zwischen sich z.B. einen spitzen Winkel von z.B. 30° bis 60° ein. Andere Winkelstellungen in der geöffneten Stellung sind ebenfalls möglich, z.B. eine steilere Anordnung mit einem Winkel von bis z.B. 90°, oder auch flachere Anordnungen mit einem Winkel z.B. bis oder bis nahezu 0°, d.h. die beiden Deckelteile 6A, 6B liegen (nahezu) flach aufeinander auf und das eine Deckelteil 6B lässt sich um (nahezu) 180° umklappen.

Insbesondere sind die beiden Deckelteile 6A, 6B über ein Filmscharnier 14 miteinander verbunden, durch die die Schwenkachse S definiert ist. Das Filmscharnier 14 ist durch eine Materialverringerung ausgebildet, wie dies allgemein üblich ist. Im Ausführungsbeispiel weist ein jedes Deckelteil 6A, 6B zumindest ein Verschlusselement 12 auf, sodass jedes Deckelteil 6A, 6B individuell mit dem Grundgehäuse 4 verrastet ist.

Die Elektrobox 2 ist insbesondere als eine Verteilerbox ausgebildet, in die mehrere elektrische Leitungen 16 hineingeführt sind. Bei diesen handelt es sich insbesondere um Versorgungsleitungen, über die elektrische Leistung bereitgestellt wird. Innerhalb der Elektrobox 2 sind mehrere elektrische Komponenten angebracht, mit deren Hilfe die Leitungen 16 in geeigneter Weise miteinander verbunden und elektrisch kontaktiert sind.

Wie insbesondere anhand der Figuren 2-7 gut zu erkennen ist, weist das eine, nachfolgend als erstes Deckelteil bezeichnete Deckelteil 6A eine Federlasche 18 auf, welche durch einen ersten Trennschlitz 20A aus dem Deckelboden 8 des ersten Deckelteils 6A freigeschnitten ist. Der erste Trennschlitz 20A umgibt daher die Federlasche 18 im Ausführungsbeispiel U-förmig, sodass diese lediglich noch mit einer Basis mit dem restlichen ersten Deckelteil 6A verbunden ist.

Das andere, nachfolgend als zweites Deckelteil bezeichnetes Deckelteil 6B weist einen Raststeg 22 auf. Dieser tritt aus der Ebene des zweiten Deckelteils 6B und damit der x-y Ebene hervor und ist insbesondere senkrecht zum zweiten Deckelteil 6B orientiert. In der geschlossenen Stellung, wie sie in den Figuren 2 und 3 dargestellt ist, befindet sich auch das erste Deckelteil 6A und damit auch die Federlasche 18 innerhalb der gemeinsamen x-y-Ebene, so dass also der Raststeg 22 aus der durch die Federlasche 18 gebildeten Ebene hervortritt, wenn sich der Deckel 6 in der geschlossenen Stellung befindet.

Im Ausführungsbeispiel ist am Raststeg 22 auf der dem Filmscharnier 14 gegenüberliegenden Seite noch ein Verstärkungselement in Form eines Verstärkungsstegs angeformt. Dieser ist nach Art einer vertikal vom Raststeg 22 abstehenden Rippe ausgebildet.

Auf der zur Federlasche 18 orientierten Seite des Raststegs 22 schließt sich an diesen eine Decklasche 24 an. Diese bildet quasi eine Verlängerung des Deckelbodens 8 des zweiten Deckelteils 6B. Die Decklasche 24 ist über einen zweiten Trennschlitz 20B freigeschnitten und steht daher in Richtung zur Federlasche 18 frei ab. Der zweite Trennschlitz 20B ist vorzugsweise wiederum U-förmig umlaufend ausgebildet. Hervorzuheben ist, dass die Decklasche 24 sich über die Schwenkachse S und über das Filmscharnier 14 hinweg erstreckt und dadurch sich insbesondere auch ein Stück weit in das erste Deckelteil 6A hinein erstreckt. Das Filmscharnier 14 ist daher durch die Decklasche 24 unterbrochen.

Die sich in Querrichtung (y-Richtung) erstreckende Breite der Federlasche 18 und der Decklasche 24 sowie vorzugsweise auch ergänzend des Raststegs sind bevorzugt zumindest weitgehend und vorzugsweise genau gleich. Die sich in Längsrichtung (x-Richtung) erstreckenden Abschnitte der ersten und zweiten Trennschlitze 20A, 20B fluchten daher miteinander. Zwischen den beiden Laschen 18, 20 ist weiterhin ein gemeinsamer dritter, quer (in y-Richtung) verlaufender Trennschlitz 20C ausgebildet. Dieser bildet zugleich einen quer verlaufenden Abschnitt des ersten sowie des zweiten Trennschlitzes 20A, 20B aus. Die verschiedenen Trennschlitze 20A, 20B, 20C sind insbesondere in den FIG 2 und FIG 7 gut zu erkennen.

Wie insbesondere anhand der Querschnittsdarstellung gemäß FIG 3 gut zu erkennen ist, ist die Federlasche 18 gegenüber dem restlichen ersten Deckelteil 6A verjüngt, weist also eine Wanddicke D1 auf, welche geringer ist als die Wanddicke D2 des zu der Federlasche 18 benachbarten Bereichs des ersten Deckelteils 6A.

Bevorzugt weist der gesamte Deckelboden 8 durchgehend eine konstante Wanddicke D2 auf, bis auf die Bereiche der beiden Laschen 18, 24 sowie des Raststegs 22 mit dem eventuellen Verstärkungssteg.

Weiterhin ist anhand der FIG 3 zu erkennen, dass sich die Decklasche 24 in Richtung zu der Federlasche 18 bevorzugt verjüngt, wobei insbesondere lediglich eine dem Grundgehäuse 4 zugewandte Unterseite schräg verläuft, während eine gegenüberliegend Oberseite plan und parallel / innerhalb der x-y-Ebene des zweiten Deckelteils 6B verläuft. Die Decklasche 24 ist an ihrem freien Ende z.B. nach Art eines Keils ausgebildet.

Der besondere Vorteil der Decklasche 24 besteht darin, dass dadurch der dritte Trennschlitz 20C möglichst schmal bei gleichzeitig einfacher Herstellung des Deckels 6 als Spritzgussbauteil ausgebildet ist.

Insgesamt sind sämtliche Trennschlitze 20A, 20B, 20C schmal ausgebildet mit einer Schlitzbreite b, die kleiner 2,5 mm und insbesondere kleiner 2 mm und beispielsweise im Bereich zwischen 1 mm und 2 mm liegt. Hierdurch ist die Schutzart gemäß IP 32 erreicht.

In einer alternativen Variante ohne Decklasche 24 verläuft das Filmscharnier 14 vorzugsweise durchgehend über die gesamte Breite des Deckels 6. In Richtung zur Federlasche 18 schließt sich an das Filmscharnier 14 noch ein schmaler und in Querrichtung verlaufender Materialsteg des ersten Deckelteils 6A an. Der erste Trennschlitz 20A verläuft wiederum U-förmig, wobei dessen in Querrichtung (y-Richtung) verlaufender Abschnitt das vordere Ende der Federlasche 18 von dem Materialsteg trennt. Im zweiten Deckelteil 6B ist kein Trennschlitz und keine Freischneidung vorgesehen.

Über die Federlasche 18 und dem Raststeg 22 ist allgemein eine Arretierung eines jeweiligen Deckelteils 6A, 6B in der geöffneten, aufgeklappten Stellung ermöglicht. Im Ausführungsbeispiel gemäß den Figuren 4, 5 und 6 ist das zweite Deckelteil 6B relativ zum ersten Deckelteil 6A um die Schwenkachse S aus der x-y-Ebene heraus verschwenkt. Grundsätzlich kann auch das erste Deckelteil 6A um die Schwenkachse S bezüglich des zweiten Deckelteils 6B aus der x-y-Ebene heraus verschwenkt werden. Vor dem Verschwenken sind bei dem hier beschriebenen Ausführungsbeispiel zunächst jeweils die relevanten Verschlusselemente 12 des jeweiligen Deckelteils 6B zu lösen, sodass dieses verschwenkt und aufgeklappt werden kann. Allgemein sind die beiden Deckelteile 6A, 6B relativ zueinander um die Schwenkachse S verschwenkbar.

Bei der Schwenkbewegung von der geschlossenen Stellung (FIG 2, FIG 3, FIG 7) in die aufgeklappte, offene Stellung (FIG 4, FIG 5, FIG 6) wird die Federlasche 18 elastisch gebogen, sobald sie den Raststeg 22 erreicht, bzw. sobald der Randsteg 22 die Federlasche 18 erreicht, bis die Federlasche 18 schließlich über den Randsteg 22 schnappt und dadurch die Arretierung ausgebildet wird, in der die beiden Deckelteile 6A, 6B zueinander in der offenen Stellung fixiert sind (vgl. hierzu insbesondere auch FIG 6).

Zum Schließen des Deckels 6 erfolgt der umgekehrte Bewegungsablauf, wobei hierzu wiederum die elastische Federlasche 18 gebogen wird, bis die zuvor ausgebildete Arretierung durch den Hintergriff mit dem Raststeg 22 wieder aufgehoben wird.

Im Ausführungsbeispiel sind die Federlasche 18 sowie der Raststeg 22 in einem Mittenbereich und insbesondere ausschließlich in einem Mittenbereich des Deckels 8 angebracht. Alternativ können auch mehrere Federlaschen - Raststeg-Paare in Querrichtung verteilt angeordnet sein, beispielsweise zwei Paare.

Insgesamt ist durch die hier beschriebene Ausgestaltung mit dem Zusammenwirken der freigeschnittenen Federlasche 18 und dem Raststeg 22 eine sehr einfache Deckelkontur ausgebildet, über die eine zuverlässige und einfache Verschwenkbarkeit der Deckelteile 6A, 6B sowie deren Arretierung in der offenen Stellung ermöglicht ist. Der gesamte Deckel 6 ist insgesamt als ein monolithisches Spritzgussteil ausgebildet. Zumindest der Deckelboden 8 mit den an der Schwenk- und Arretierungsfunktion beteiligten Elementen, nämlich Federlasche 18, Raststeg 22 sowie insbesondere auch Decklasche 24 und ergänzend auch Filmscharnier 14, ist insgesamt ohne Hinterschneidungen ausgebildet, sodass eine Spritzgussform zur Herstellung des Deckels 6 einfach aufgebaut sein kann. Insgesamt ist durch die hier beschriebene Ausgestaltung auch eine sehr flache Bauweise erreicht.

### Bezugszeichenliste

- 2: Elektrobox
- 4: Grundgehäuse
- 6: Deckel
- 6A: erstes Deckelteil mit Federlasche
- 6B: zweites Deckelteil mit Raststeg
- 8: Deckelboden
- 10: Randsteg
- 12: Verschlusselement
- 14: Filmscharnier
- 16: elektrische Leitung
- 18: Federlasche
- 20A: erster Trennschlitz
- 20B: zweiter Trennschlitz
- 20C: dritter Trennschlitz
- 22: Raststeg
- 24: Decklasche

- S: Schwenkachse
- D1, D2: Wandbreite
- b: Schlitzbreite

## Patentansprüche

1. Elektrobox (2) für ein Kraftfahrzeug mit zwei Teilen, nämlich einem Deckelteil (6A, 6B) und einem weiteren Teil (6B, 6A), wobei das Deckelteil (6A, 6B) relativ zu dem weiteren Teil (6B, 6A) von einer geschlossenen Stellung in eine geöffnete Stellung um eine Schwenkachse (S) aufklappbar und in der geöffneten Stellung arretierbar ist, **dadurch gekennzeichnet, dass** in einem der beiden Teile (6A) eine Federlasche (18) mit Hilfe eines Trennschlitzes, nämlich mit Hilfe eines ersten Trennschlitzes (20A) freigeschnitten ist und dass an dem anderen Teil (6B) ein Raststeg (22) angeordnet ist, welcher beim Überführen des Deckelteils (6A, 6B) in die geöffnete Stellung von der Federlasche (18) hintergriffen wird und dadurch das Deckelteil (6A, 6B) in der geöffneten Stellung arretiert.

2. Elektrobox (2) nach dem vorhergehenden Anspruch, **dadurch gekennzeichnet, dass** das weitere Teil ebenfalls ein Deckelteil (6B, 6B) ist und die beiden Deckelteile (6A, 6B) einen gemeinsamen Deckel (6) ausbilden.

3. Elektrobox (2) nach dem vorhergehenden Anspruch, **dadurch gekennzeichnet, dass** der Deckel (6) einstückig ist und die beiden Deckelteile (6A, 6B) über ein Filmscharnier (14) miteinander verbunden sind.

4. Elektrobox (2) nach einem der vorhergehenden Ansprüche, **dadurch gekennzeichnet, dass** die Federlasche (18) eine Wanddicke (D1) aufweist, die im Vergleich zu einer Wanddicke (D2) des der Federlasche (18) benachbarten Bereichs reduziert ist.

5. Elektrobox (2) nach einem der vorhergehenden Ansprüche, **dadurch gekennzeichnet, dass** der Raststeg (22) - wenn sich das Deckelteil (6A, 6B) in der geschlossenen Stellung befindet - aus einer Ebene der Federlasche (18) insbesondere senkrecht heraustritt.

6. Elektrobox (2) nach einem der vorhergehenden Ansprüche, **dadurch gekennzeichnet, dass** ausgehend vom Raststeg (22) eine Decklasche (24) ausgebildet ist, welche in Richtung zu der Federlasche (18) orientiert ist und sich über die Schwenkachse (S) hinweg erstreckt.

7. Elektrobox (2) nach dem vorhergehenden Anspruch, **dadurch gekennzeichnet, dass** die Decklasche (24) fest mit dem Raststeg (22) verbunden ist und sich innerhalb der Ebene der Federlasche (18) erstreckt, wenn sich das Deckelteil (6A, 6B) in der geschlossenen Stellung befindet.

8. Elektrobox (2) nach einem der beiden vorhergehenden Ansprüche sowie nach Anspruch 3, **dadurch gekennzeichnet, dass** das Filmscharnier (14) im Bereich der Decklasche (24) unterbrochen ist, so dass also die Decklasche (24) über einen Trennschlitz, nämlich über einen zweiten Trennschlitz (20B), freigeschnitten ist.

9. Elektrobox (2) nach einem der Ansprüche 6 bis 8, **dadurch gekennzeichnet, dass** zwischen der Federlasche (18) und der Decklasche (24) ein Trennschlitz, nämlich ein dritter Trennschlitz (20C) ausgebildet ist.

10. Elektrobox (2) nach einem der vorhergehenden Ansprüche, **dadurch gekennzeichnet, dass** der Trennschlitz (20A, 20B, 20C) eine maximale Schlitzbreite (b) kleiner 2,5 mm und insbesondere kleiner 2 mm aufweist.

11. Elektrobox (2) nach einem der vorhergehenden Ansprüche, **dadurch gekennzeichnet, dass** sie als eine Verteilerbox ausgebildet ist, in die im montierten Zustand mehrere elektrische Leitungen (16) hineingeführt sind.
